# EUROPEAN PATENT APPLICATION

(11) **EP 1 437 616 A1**
(43) Date of publication of application: **14.07.2004**
(21) Application number: 03447004.7
(22) Date of filing: 10.01.2003
(51) Int. Cl.: G02B 23/24, H01S 3/0933, G02B 6/42

(54) **Optical fiber with integrated pump light source**

(71) Applicant: INTERUNIVERSITAIR MICROELEKTRONICA CENTRUM ( IMEC), 3001 Leuven (BE)
(72) Inventor: Arkhipov, Vladimir, 3000 Leuven (BE); Heremans, Paul, 3000 Leuven (BE)
(74) Representative: Van Malderen, Joelle

(57) **Abstract**

The present invention is related to an optical device, comprising:
- an optical cable (1), having an axial symmetry, comprising a core (11), doped with phosphorescent or fluorescent impurities, and a transparent envelope (12,13);
- said transparent envelope (12,13) further comprising a cladding layer (12) and optionally a jacket layer (13), surrounding said cladding layer (12);
- an associated light source (2) comprising:
   - an inner electrode (21),
   - an outer electrode (22), and
   - an active area, located between said inner electrode and said outer electrode (23),
   wherein
- said light source (2) and said optical cable (1) are integrated;
- said light source (2) has an axial symmetry and is positioned coaxially to said optical cable (1); and
- said inner electrode (21) is transparent, such that light, generated in said active area (23) can propagate outside said light source and into said optical cable (1).

## Description

### Field of the invention

The present invention is related to the fields of fibre optics and flexible, preferably organic, light-emitting diodes.

### State of the art

Coupling optics is usually required to couple the light produced by a Lambertian light source into an optical fibre, because the fibre has a limited numerical aperture. An example of a Lambertian light source is a Light Emitting Diode (LED). An example of a method for coupling light produced by a light-source (LED) into a fibre is disclosed in JP2001078961, wherein light originating from different LEDs is coupled into a fibre by focusing means. In DE10054552 light produced by a LED is coupled into a fibre by using a lens.

### Aims of the invention

The present invention aims to provide an integrated optical device, comprising an optical fibre pumped by an integrated flexible light source positioned coaxially with the optical fibre and whereby no optical coupling devices are required.

It is a further aim of the invention to provide an integrated optical device wherein an optical fibre is pumped with an essentially coaxial organic light-emitting diode.

It is a further aim of the invention to provide an integrated optical device that can be used to generate optical signals.

It is a further aim of the invention to provide an integrated optical device that can be used to amplify or regenerate optical signals (also called repeater).

It is a further aim of the invention to provide an integrated optical device that, at higher excitation intensities, represents a fibre laser.

It is a further aim of the invention to provide an integrated optical device, comprising optical cable and light source that can be manufactured in the same technological process.

It is a further aim of the invention to provide an integrated optical device, which can be used for introscopic, for instance endoscopic, purposes.

### Summary of the invention

The present invention is related to an optical device, comprising:
- an optical cable, having an axial symmetry, comprising a core, doped with phosphorescent or fluorescent impurities, and a transparent envelope;
- said transparent envelope further comprising a cladding layer and optionally a jacket layer, surrounding said cladding layer;
- an associated light source, comprising:
   - an inner electrode,
   - an outer electrode, and
   - an active area, located between said inner electrode and said outer electrode;
wherein said light source and said optical cable are integrated, said light source has an axial symmetry and is positioned coaxially to said optical cable, and said inner electrode is transparent, such'that light, generated in said active area can propagate outside said light source and into said optical cable.

Advantageously, said outer electrode is reflective.

Advantageously, said light-source is flexible, and can be a mono- or multi-layer organic light-emitting diode (OLED).

According to a first embodiment, said outer electrode is transparent and said light-source comprises an additional outer layer which is reflective.

Advantageously, the device according to the invention further comprises mirrors on both sides of the optically pumped region, one mirror being not transparent, the other mirror being partially transparent. Advantageously, said device is a laser.

Preferably, the efficiency of absorption of light in said core, said light produced by said light source, is a function of Pe/Pc, and advantageously, said efficiency is controlled by choosing Pe/Pc appropriately.

The device according to the invention can be used as an optical signal generator, and advantageously, said optical signal is constant.

The device according to the invention can also be used as an optical signal amplifier or repeater.

The device according to the invention can be used for introspection or endoscopy.

### Short description of the drawings

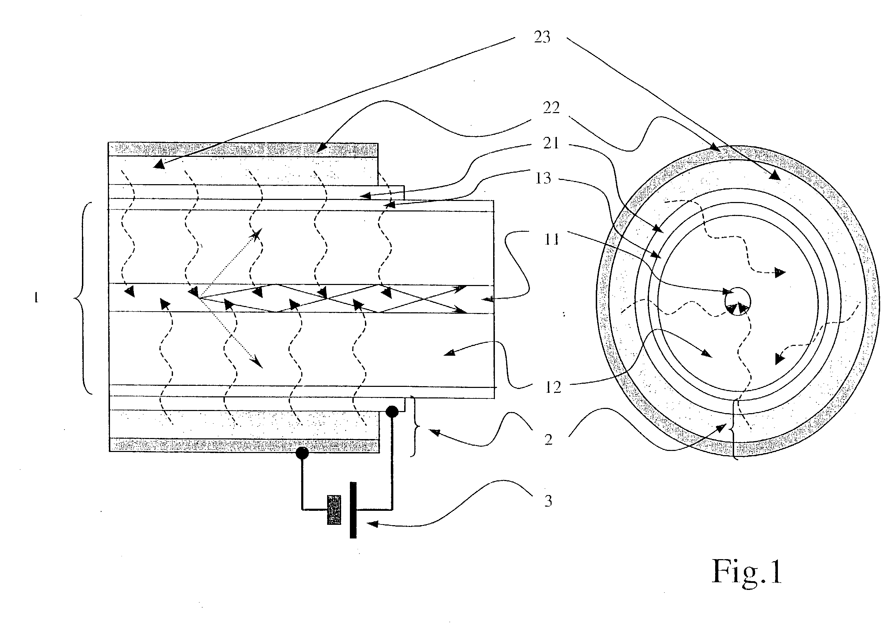

Fig. 1 represents axial and radial cross sections of the first embodiment of the present invention, with a fibre (1), comprising a fibre core (11) embedded into a transparent envelope, comprising a cladding layer (12) and transparent jacket layer (13) (optional), said envelope being coated by an essentially coaxial organic light-emitting diode (2) comprising a transparent inner electrode (21), an active area (23) and a reflecting metallic outer electrode (22), and a power supply (3).

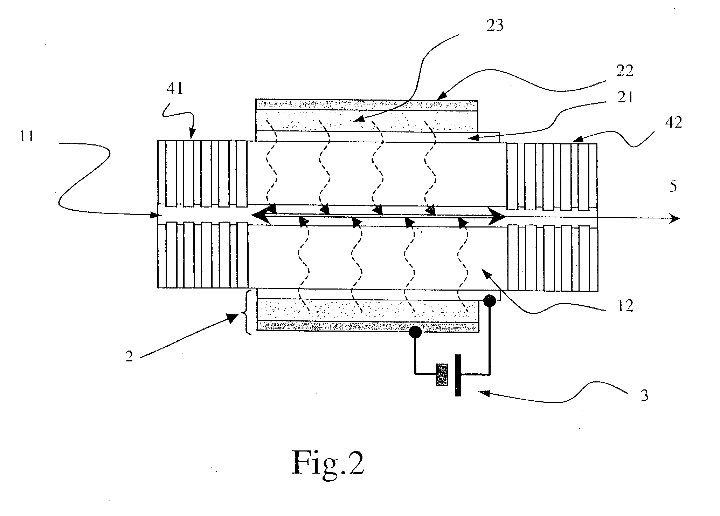

Fig. 2 illustrates the second embodiment of the present invention, an OLED-pumped dye-doped fibre laser, where the OLED pumped region is enclosed between grating mirrors. Here the optional jacket layer is not depicted.

### Description of a preferred embodiment of the invention

In a first embodiment of the present invention represented in Fig.1, a novel optical device comprising an optical cable or fibre 1 and an associated structure 2,3 is disclosed. It involves an optical fibre 1 pumped by a co-axial flexible light-emitting diode 2 (LED). The fibre can be a plastic optical fibre, a glass fibre, or another type of optical fibre. Optical fibres are known to be flexible. An optical cable or fibre 1 comprises an organic or inorganic core 11 doped with either fluorescent or phosphorescent impurities, called dyes (preferably organic dyes or metals, preferably rare earth metals like Erbium, Terbium, Europium, etc.) and located in a transparent envelope 12,13. The envelope comprises a cladding layer 12 and optionally an additional jacket layer 13 (part of the envelope and thus transparent). The jacket layer can improve the adhesion between the envelope and the flexible light emitting diode and can increase mechanical strength of the fibre.

In a first aspect of the first embodiment of the present invention, the envelope is coated with a coaxial mono- or multi-layer organic light-emitting diode 2. OLEDs have three prominent features namely (i) easy production of OLEDs with large active areas, (ii) possibility of producing non-planar light-emitting surfaces, and (iii) flexibility of OLEDs comparable with or even exceeding that of optical cables. It is the unique combination of those properties that allows to integrate an OLED essentially coaxially with an optical fibre as described in the present invention. The OLED according to the present invention has a transparent inner electrode 21 (e.g. Indium Tin Oxide (ITO)). The OLED has a reflective, preferably metallic (e.g. Al, Ca, Ag, Au,...), outer electrode 22. The active area 23 can be a mono layer or a multi layer structure. The active layer(s) can be made of organic materials, such as for example conjugated polymers as for instance polyphenylenevinylene (PPV) and derivatives thereof. The active layer(s) can also be made of small organic molecules as for instance *Alq*₃.

As shown in Fig. 1, light emitted by the OLED can penetrate the optically passive transparent inner electrode 21 and envelope 12,13 and can excite dye molecules in the core 11 of the optical fibre. The light that does not pass through the fibre core 11 traverses the envelope 12,13 and the OLED stack of layers until it can be reflected by the outer reflecting electrode 22 of the OLED. Due to the Stokes shift the emitted light cannot be strongly absorbed in the active area 23 of the OLED. Also, the envelope 12,13 is essentially transparent for this light. Therefore, multiple reflections are possible before the light ultimately penetrates into the fibre core 11. These multiple reflections enhance the light flux that finally penetrates into the fibre core 11 as compared to the light flux emitted by the OLED surface along the direction to the fibre core. The light emitted by the OLED can be advantageously chosen to lie in the absorption band of dye dopants that are incorporated in the fibre core 11. Within the fibre core 11, the OLED-pumped light therefore excites said dye dopants that subsequently emit photons along various directions. A fraction of the light emitted by said dopants will be wave-guided within the optical fibre.

At low excitation intensities, a part of the light waves emitted by dopants via spontaneous fluorescence or phosphorescence will satisfy the condition of full internal reflectance at the boundary between core 11 and cladding 12 and will be guided along the fibre.

Enhanced emission causes stimulated emission in the fibre core 11 and the integrated device can be used for optical signal generation, regeneration and amplification.

In a second embodiment of the present invention, shown in Fig. 2, mirrors 41, 42 are applied to both ends of the pumped fibre region. Such mirrors can be formed by technologies known to a person skilled in the art, for example by etching a pair of fibre phase gratings into the core 11 of the fibre that act like Bragg gratings or by depositing a reflective material on cleaved fibre ends. One of both mirrors can be partially transparent 42. As the intensity of the light absorbed in the fibre core 11 reaches the threshold for stimulated emission to occur, optical gain can be provided into the cavity formed between the mirrors 41,42. This threshold can be reached at higher light fluxes generated by the OLED. Lasing output 5 can then be achieved in the OLED-pumped doped fibre.

An aspect of the first and second embodiments of the present invention is that the ratio of maximum pumping light flux that finally penetrates into the fibre core to the light flux emitted by the OLED surface (called efficiency) can be modelled as a function of the ratio of the perimeter of the envelope 12,13 to the perimeter of the core 11, Pe/Pc. This ratio can be designed to be one or several orders of magnitude by varying the radii of the core (Rc) and the envelope (Re). To a certain extend, the invention thus allows to control the amount of flux of light absorbed in the fibre core 11.

Another aspect of the first and second embodiments of the present invention is that theoretically some light rays of the pumping OLED can resonate in a mode that never traverses the core of the fibre. The presence of such modes can be maximally avoided, resulting in a further increased light flux of pumping light in the fibre core. In order to avoid the presence of modes that do not cross the fibre core, imperfections in the coaxial arrangement of the OLED with respect to the fibre core can be introduced. In practice such imperfection, although small, are always present. These imperfections can also be created on purpose, by for instance roughening the outer surface of the envelope before deposition of the OLED, or by roughening at least 1 layer which is part of the integrated optical device, before adding the next layer(s). In those cases, the surface structure of the outer reflecting layer changes the angle of propagation at every reflection.

Yet another aspect of the first and second embodiments of the present invention, the OLED device has a transparent outer electrode and comprises an additional outer layer on top of the outer electrode, which is reflective. Light produced by the OLED can then pass through the transparent outer electrode and reflect from this additional reflective outer layer.

Yet another aspect of the present invention is that the light-source can increase mechanical strength of the optical cable.

The optical devices according to the first and second embodiments of the present invention can be produced by rotating the optical fibre (for which production in known in the art) while adding deposition material on the fibre in a controlled way such that homogeneous layers can be achieved.

The optical devices according to the present invention can be used for introscopic purposes as for instance endoscopic purposes.

## Claims

1. Optical device, comprising:
- an optical cable (1), having an axial symmetry, comprising a core (11), doped with phosphorescent or fluorescent impurities, and a transparent envelope (12,13);
- said transparent envelope (12,13) further comprising a cladding layer (12) and optionally a jacket layer (13), surrounding said cladding layer (12);
- an associated light source (2), comprising:
- an inner electrode (21),
- an outer electrode (22), and
- an active area, located between said inner electrode and said outer electrode (23);
wherein
- said light source (2) and said optical cable (1) are integrated;
- said light source (2) has an axial symmetry and is positioned coaxially to said optical cable (1); and
- said inner electrode (21) is transparent, such that light, generated in said active area (23) can propagate outside said light source (2) and into said optical cable (1).

2. Device according to claim 1, wherein said outer electrode (22) is reflective.

3. Device according to claim 1 to 2, wherein said light-source (2) is flexible.

4. Device according to claim 1 to 3, wherein said light-source is a mono- or multi-layer organic light-emitting diode (OLED).

5. Device according to claim 1, 3 and 4, whereby said outer electrode (22) is transparent and said light-source comprises an additional outer layer which is reflective.

6. Device according to claim 1 to 5, further comprising mirrors (41,42) on both sides of the optically pumped region, one mirror being not transparent (41), the other mirror being partially transparent.

7. Device according to claim 1 to 6, wherefore the efficiency of absorption of light in said core (11), said light produced by said light source (2), is a function of Pe/Pc.

8. Device according to claim 7, wherefore said efficiency is controlled by choosing Pe/Pc appropriately.

9. Device as recited in claim 1 to 5, used as an optical signal generator.

10. Device as recited in claim 9, whereby said optical signal is constant.

11. Device as recited in claim 1 to 5, used as an optical signal amplifier or repeater.

12. Device according to claim 6, wherein said device is a laser.

13. Device according to claim 1 to 12, used for introspection.

14. Device according to claim 1 to 13, used for endoscopy.
